# EUROPEAN PATENT SPECIFICATION

(11) **EP 2 826 883 B1**
(45) Date of publication and mention of the grant of the patent: **03.10.2018**
(21) Application number: 13176897.0
(22) Date of filing: 17.07.2013
(51) Int. Cl.: C23C 14/54, C23C 14/56, H01J 37/34

(54) **Inline deposition control apparatus and method of inline deposition control**
Inline-Ablagerungssteuerungsvorrichtung und Verfahren zur Inline-Ablagerungssteuerung
Appareil de commande de dépôt en ligne et procédé de commande de dépôt en ligne

(43) Date of publication of application: 21.01.2015
(73) Proprietor: Applied Materials, Inc., Santa Clara, CA 95054 (US)
(72) Inventor: Lotz, Hans-Georg, 63584 Gründau-Rothenbergen (DE)
(74) Representative: Zimmermann & Partner Patentanwälte mbB

(56) References cited:
- WO-A1-2011/046050
- US-B1- 6 447 652
- US-B1- 6 733 821

## Description

### TECHNICAL FIELD OF THE INVENTION

Embodiments of the present disclosure relate to inline deposition control for a vacuum deposition apparatus and an apparatus for controlling inline deposition of a vacuum deposition apparatus. Specifically, embodiments relate to controlling inline deposition onto a flexible substrate, especially for optical multilayer systems.

### BACKGROUND OF THE INVENTION

In many applications, it is necessary to deposit thin layers on a flexible substrate. Typically, the flexible substrates are coated in one or more chambers of a flexible substrate coating apparatus. Further, a stock of a flexible substrate, for example, a roll of a flexible substrate, may be disposed in one chamber of the substrate coating apparatus. Typically, the flexible substrates are coated in a vacuum, using a vapor deposition technique, for example, physical vapor deposition or chemical vapor deposition.

Roll to roll coaters typically allow for high throughput in light of the high speed at which the flexible substrate can be guided through the deposition system. Further, the flexible substrates such as films or the like can result in lower manufacturing prices as compared to similar layer stacks deposited on a glass substrate. One example, of an application can be layer stacks for touch panels. Touch panels are a particular class of electronic visual displays, which are able to detect and locate a touch within a display area. Generally, touch panels include a transparent body disposed over a screen and configured to sense a touch. Such a body is substantially transparent, so that light in the visible spectrum emitted by the screen can be transmitted therethrough. A common manufacturing process for touch panel applications can be a sputtering process, wherein a touch panel coating is deposited on a plastic film using a roll-to-roll sputter web coater. There are several types of touch panel coatings on the market.

In the coating process, it is desirable to monitor and control the respective thickness of the one or more layers which are deposited onto the substrate in order to achieve the specified properties of the layer system. Such properties may include optical properties like antireflection, solar control, an invisible tin-oxide layer, low emissivity or others. Typical layer systems include 2 to 10 layers, wherein a correct determination of the respective layer thicknesses becomes increasingly difficult with a higher number of layers. It is therefore desirable to improve the control of the deposition process, especially for multilayer deposition processes. US Patent Application No. US 6,447,652 B1 discloses an RF plasma CVD apparatus wherein a sputtering method may be applied for depositing a DLC film on an evaporated tape. It further comprises a laser oscillator that emits a laser beam to irradiate the DLC film. Moreover, a Raman scattered light reflected by the DLC film is collected by a probe. If the Raman spectrum is changed, the film forming conditions may be restored in order to achieve a predetermined thickness of the DLC film. US Patent Application No. US 6,733,821 B1 discloses an optical thin layer forming apparatus having two evaporation sources, a light emitting unit and a light detection unit. Furthermore, it comprises a control unit which controls the thickness of one film layer of a plurality of alternately stacked layers that constitute a multilayer film.

### SUMMARY OF THE INVENTION

In light of the above, an inline deposition control apparatus for a vacuum deposition apparatus according to independent claim 1 and a method of inline deposition control for a vacuum deposition apparatus according to independent claim 13 are provided. Further aspects, advantages and features of the present invention are apparent from the dependent claims, the description and the accompanying drawings.

According to one embodiment, an inline deposition control apparatus for a vacuum deposition apparatus having more than one deposition sources for depositing more than one deposition layers on a substrate is provided. The inline deposition control apparatus includes one or more light sources adapted to illuminate the substrate having the more than one deposition layers. The inline deposition control apparatus further includes a detection arrangement adapted for spectrally resolved detection of a measurement signal, wherein the measurement signal is selected from at least one of: light reflected at the substrate having the more than one deposition layers, and light transmitted through the substrate having the more than one deposition layers. Furthermore, the inline deposition control apparatus includes an evaluation unit to determine the respective thicknesses of the more than one layers based on the measurement signal, and a controller connected to the evaluation unit and connectable to the deposition apparatus for feed-back control of the deposition of the more than one deposition layers based on the determined thicknesses.

According to another embodiment, a method of inline deposition control for a vacuum deposition apparatus is provided. The method includes illuminating a substrate on which more than one deposition layers have been deposited, measuring a spectrally resolved signal selected from at least one of: light reflected at the substrate having the more than one deposition layers, and light transmitted through the substrate having the more than one deposition layers, determining the respective thicknesses of the more than one layers based on the measurement signal and a set of setpoint parameters of the deposition of the more than one deposition layers, and feed-back controlling of the deposition of the more than one deposition layers based on the determined thicknesses.

Embodiments are also directed at apparatuses for carrying out the disclosed methods and include apparatus parts for performing each described method step. These method steps may be performed by way of hardware components, a computer programmed by appropriate software, by any combination of the two or in any other manner. Furthermore, embodiments according to the invention are also directed at methods by which the described apparatus operates. It includes method steps for carrying out every function of the apparatus.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- FIG. 1: shows the optical density vs. layer thickness for Al and Au layers at 800 nm wavelength;
- FIG. 2: shows the spectral reflectance of a titanium oxide single layer;
- FIG. 3: shows a deposition apparatus for depositing a layer on a flexible substrate and being adapted for inline deposition control according to embodiments described herein;
- FIG. 4: shows another deposition apparatus for depositing a layer on a flexible substrate and being adapted for inline deposition control according to embodiments described herein;
- FIG. 5: shows an arrangement of several measurement heads located across the width of the substrate according to embodiments described herein;
- FIG. 6: shows a movable measurement head according to embodiments described herein; and
- FIG. 7: shows a flow chart for illustrating a method of inline deposition control according to embodiments described herein;
- FIG. 8: shows an exemplary multilayer system which can be inspected by embodiments described herein;
- FIG. 9: shows a flowchart of inline deposition control according to embodiments described herein;
- FIG. 10: shows an exemplary comparison between desired and actual spectral curves.

### DETAILED DESCRIPTION OF EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. Further, features illustrated or described as part of one embodiment can be used on or in conjunction with other embodiments to yield yet a further embodiment. It is intended that the description includes such modifications and variations.

A flexible substrate or web as used within the embodiments described herein can typically be characterized in that it is bendable. The term "flexible substrate" or "web" may be synonymously used with the term "strip". For instance, the web as described in embodiments herein may be a foil, a film, or the like.

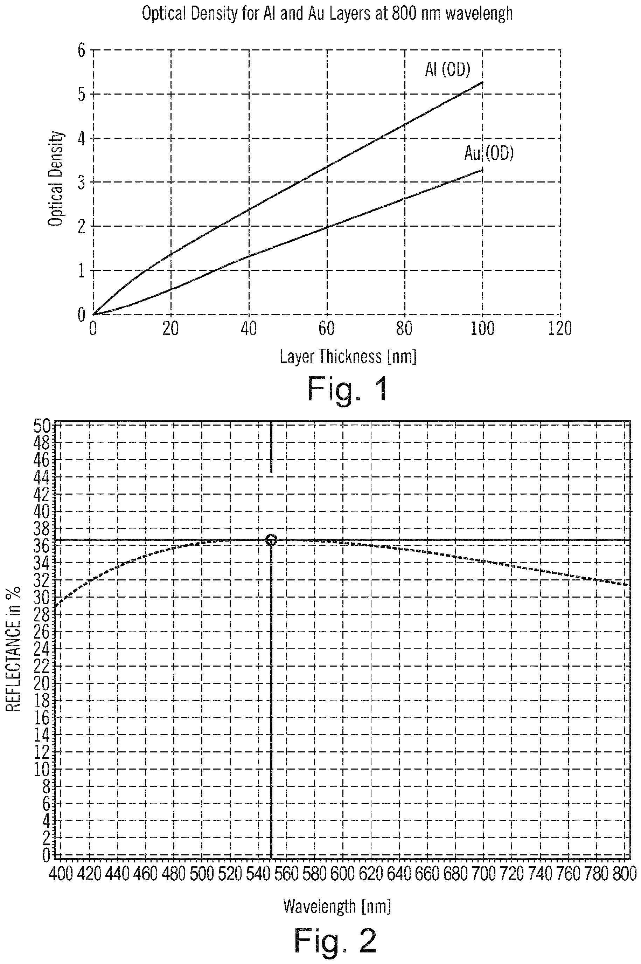

Embodiments of the apparatus and methods described herein relate to inline deposition control of layers deposited on a substrate. The relationship between layer thickness and optical density at a single wavelength (800 nm) is shown in FIG. 1 for Al and Au single layers. The thickness of thin metallic layers, e.g. an Al layer, may be calculated by measuring the optical density OD (OD= -ln(T/T₀)) at a single wavelength, wherein T₀ is the transmittance without substrate and the layer (or the substrate alone) and T is the transmittance of the substrate with the layer deposited thereon. For a metallic single layer the physical thickness can thus be derived directly from the measured optical density at a single wavelength

Deposited layers, in particular, optical layers, may be characterized by their spectral reflection and transmittance curves. However, in the case of non-absorbing transparent layers the physical thickness D is derived from the maximum (minimum) position of a reflection (transmission) peak at the so called lambda-quarter position following the equation D = λ₀/(4*n), where λ₀ denotes the spectral position of the (first order) reflection or transmission peak and n denotes the refractive e index of the layer material. An example of such a spectral curve is shown in FIG. 2, which displays the spectral reflection of a single layer of Titanium Oxide with a refractive index of 2.49. The peak maximum is located at a wavelength of 550 nm so that the physical thickness is calculated as D = 550 nm/(4*2.49) = 55 nm. However, in the case of optical multilayer systems with more than one layer the situation is more complicated. The physical thickness values of the individual layers cannot be deduced easily from the spectral reflection and/or transmittance curve of the layer system, because the layers typically interact with each other by interference. Some embodiments described herein provide methods for obtaining layer thicknesses of multilayer systems and will be described in more detail below.

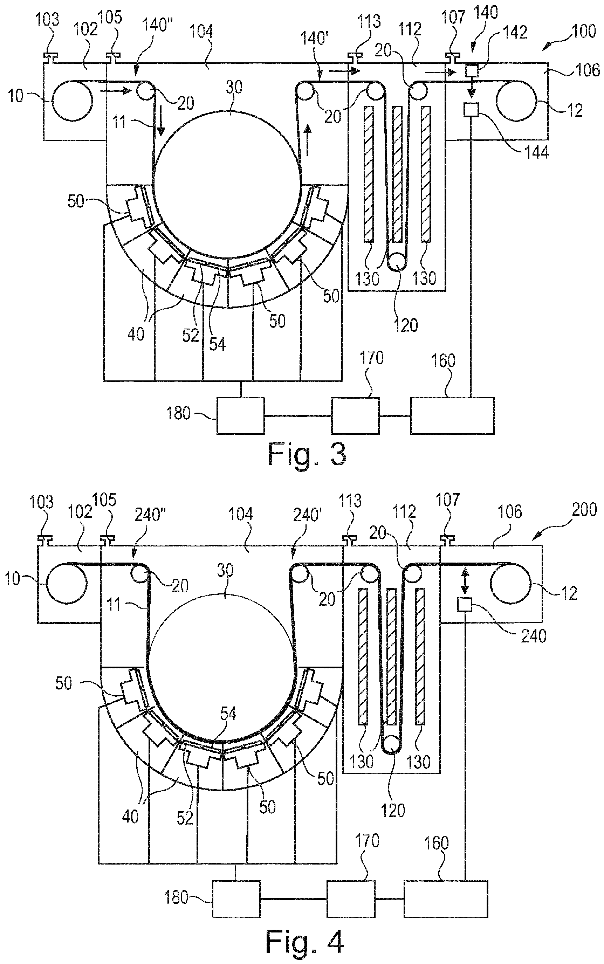

FIG. 3 illustrates an apparatus 100 for depositing one or more layers on a flexible substrate 11. Thereby, the uncoated flexible substrate can be provided on a roll 10 in the unwinding chamber 102. The flexible substrate is guided, for example through guiding rollers 20 towards the processing drum 30. One or more layers are deposited on the flexible substrate 11 while the substrate is guided through the deposition chambers or sub-chambers 40. These sub-chambers can be a portion of the deposition chamber 104. As shown in FIG. 3, the deposition sources 50 can for example be sputter targets. After depositing the one or more layers in the deposition chamber 104, the substrate 11 may further be guided through guiding rollers 20 in an optional adjacent annealing chamber 112 including three heating elements 130. According to some embodiments, which can be combined with other embodiments described herein, the annealing chamber is omitted. The coated, and optionally annealed, substrate is provided into winding chamber 106, wherein the substrate is wound on roll 12.

In the embodiment shown in FIG. 3, winding chamber 106 includes an inline transmission measurement device 140 for inspecting the coated substrate, in particular when substrate 11 is at least gradually transparent. Inline transmission measurement device 140 includes a light source 142 which is adapted to illuminate substrate 11 having the coated layers thereon. According to some embodiments, which can be combined with other embodiments described herein, more than one light source 142 may be provided. According to some embodiments, which can be combined with other embodiments described herein, the more than one light sources may be arranged at different positions across the width of substrate 11. Furthermore, inline transmission measurement device 140 includes a receiver 144 adapted for receiving the light transmitted through the coated substrate. The combination of light source 142 and receiver 144 may also be called a measurement head. Receiver 144 is connected to a detection arrangement 160 which is adapted for spectrally resolved detection of the measurement signal provided by receiver 144. According to some embodiments, which can be combined with other embodiments described herein, the detection arrangement 140 is a spectrometer. According to some embodiments, which can be combined with other embodiments described herein, the spectrometer may be adapted to determine a transmittance of the coated substrate 11 within a wavelength range of about 300 to about 1700 nm, particularly of about 380 to about 1100 nm.

According to further embodiments, which may be combined with other embodiments described herein, an inline transmission measurement device may additionally or alternatively be located at position 140' within deposition chamber 104. Such an arrangement may be particularly useful in embodiments where annealing chamber 112 is omitted. According to even further embodiments, which may be combined with other embodiments described herein, an inline transmission measurement device may additionally or alternatively be located at position 140" within deposition chamber 104. Such an arrangement is particularly useful if apparatus 100 can operate in a reverse mode where the substrate is transported in opposite directions, e.g. first from roll 10 to roll 12 and subsequently reverse from roll 12 back to roll 10.

Furthermore, apparatus 100 includes an evaluation unit 170 which is adapted to determine the respective thicknesses of the one or more layers coated on substrate 11. Typically, evaluation unit 170 receives input from detection arrangement 160 and evaluates whether the actual coating on substrate 11 corresponds to the desired layer thicknesses. The evaluation unit 170 is connected to controller 180 which, in turn, is directly or indirectly connectable to deposition sources 50 for feed-back control thereof. According to embodiments described herein, the process of inline deposition control for a vacuum deposition apparatus includes illuminating the substrate 11 on which one or more deposition layers have been deposited. The process further includes measuring a spectrally resolved signal selected from at least one of: light reflected at the substrate having the one or more deposition layers, and light transmitted through the substrate having the one or more deposition layers. In addition, the process includes determining the respective thicknesses of the one or more layers based on the measurement signal and a set of setpoint parameters of the deposition of the one or more deposition layers. The process also includes feed-back controlling of the deposition of the one or more deposition layers based on the determined thicknesses.

With such or similar arrangements and/or processes as contemplated herein, the current trial-and-error correction mechanism for adjusting the deposition apparatus to the correct layer thicknesses can be overcome. This reduces also the need for experienced operators since the adjustment is done inline and automatically. Furthermore, the amount of material which is not coated according to the specified design can be reduced. Also, the start-up time for a given process can be reduced since the correct adjustment of the deposition apparatus is achieved faster than by the conventional trial-and-error adjustment.

According to some embodiments, which can be combined with other embodiments described herein, the evaluation unit 170 has a set of setpoint parameters of the deposition of the one or more deposition layers. In some embodiments, the set of setpoint parameters contains one or more of a desired material composition of the substrate, a desired thickness of the substrate, a refractive index of the substrate, an extinction coefficient of the substrate, a desired material composition of a deposition layer, a desired thickness of a deposition layer, a number of deposition layers on the substrate, a refractive index of a deposition layer, an extinction coefficient of a deposition layer. Such setpoint parameters correspond to the desired coating which should finally be produced on the substrate. The setpoint parameters may also be considered as desired values for the coating process from which the actual, i.e. measured, values of the coating may deviate. Thus, the setpoint parameters may serve for defining a desired result of the coating process.

According to some embodiments, which can be combined with other embodiments described herein, the evaluation unit 170 is adapted to compare the spectrally resolved measurement signal with one or more simulated spectral curves based on a set of setpoint parameters. For example, the evaluation unit 170 may simulate the spectral curves itself or may be inputted with simulated spectral curves from a data source. The simulation is based on setpoint parameters corresponding to a desired coating, for example the optical parameters n and k of respective materials and thicknesses of the layers in the coating.

According to some embodiments, which can be combined with other embodiments described herein, the evaluation unit 170 is further adapted to determine an actual layer thickness for each of the one or more deposition layers from the comparison between the measurement signal and the simulated spectral curves. Embodiments of such determination methods will be described in more detail below. By way of illustration, which should not be construed as limiting, the desired coating has three layers with a first layer of 8 nm thickness, a second layer of 40 nm thickness and a third layer of 30 nm thickness. Based on these desired values and other setpoint parameters, e.g. the respective material of each layer, simulated spectral curves for the optical measurement are calculated. These calculated curves are then compared with the actual spectral curves as determined by the measurement head 140 and the detection arrangement 160 to determine a deviation of the actual spectral curves from the desired spectral curves. According to some embodiments, which can be combined with other embodiments described herein, the input parameters of the one or more simulated spectral curves may be fitted to match the spectrally resolved measurement signal, i.e. the actual spectral curves. For example, the value of the respective layer thicknesses may be adjusted until the simulated curves match the measured spectral curves. From this fit, the actual layer thicknesses may be determined. By way of illustration only, the fit may reveal a layer thickness of 6 nm for the first layer, a layer thickness of 45 nm for the second layer and a layer thickness of 32 nm for the third layer. Accordingly, the first layer deviates by -2 nm from the desired thickness, the second layer by +5nm, and the third layer by + 2 nm.

According to some embodiments, which can be combined with other embodiments described herein, the controller 180 is adapted to control at least one sputter source 50 for depositing at least one of said deposition layers. In the particular example described above, controller 180 may increase the output of the sputter source for the first layer by 33%, and decrease the output of the sputter source for the second layer by 11% and for the third layer by 6.3% in order to adjust the actual layer thicknesses to the desired values. For example, such adjustment may be done by controlling the power of the sputter source. However, in some embodiments other deposition sources may be used, in which case the output of the source may be controlled in a different manner, e.g. by controlling gas flow in a vapor deposition source.

According to some embodiments, which can be combined with other embodiments described herein, the inline deposition control apparatus is adapted for inline inspection of a substrate that is conveyed at a speed of about 0.005 to about 0.5 m/s. Such an inline deposition control apparatus allows for continuous monitoring of the coating without slowing down the throughput of the deposition apparatus.

According to some embodiments, which can be combined with other embodiments described herein, the inline deposition control apparatus is adapted for inline inspection of a substrate which has a transverse width of about 200 to about 2000 mm. Such an inline deposition control apparatus allows for continuous monitoring of typical substrates.

According to some embodiments, which can be combined with other embodiments described herein, the inline deposition control apparatus is adapted for inline inspection of a substrate which is under a tension of 20 to 800 N when being transported. Such tension may change the optical properties of the coated substrate so that taking it into account reduces the deviation between the desired and the actual coating on the substrate.

According to typical embodiments, the deposition material for a respective layer is selected from Ag, Al, Au, Cr, Cu, Mo, Ni, NiCr, NiV, Si, stainless steel, Ti, TiO₂, Ta, Al₂O₃, aluminum-doped zinc oxide (AZO), CrOₓN_{y}, indium-doped tin oxide (ITO), MgO, Nb₂O₅, SiN, SiO₂, and SiOₓN_{y}. A respective coating material may be reflected in the setpoint parameters which are chosen for the simulated spectral curves.

According to typical embodiments, the substrate is selected from polyethylene terephthalate, polyethylene naphthalate, polyimide, polyamide, polycarbonates, triacetyl cellulose, and metal foils. A respective substrate may be reflected in the setpoint parameters which are chosen for the simulated spectral curves.

According to some embodiments, which can be combined with other embodiments described herein, the heating, i.e. the annealing, can be conducted at a temperature of the heating element of 150°C and above. Typically, the temperature can be 150°C to 180°C. For some types of flexible substrates, the heating can be in the range of 150°C to 250°C, for example 150°C to 210°C. The respective annealing temperature may be reflected in the setpoint parameters for the simulated spectral curves.

According to embodiments described herein, the apparatus 100 includes an unwinding module having an unwinding chamber 102, a deposition module having a deposition chamber 104, and an optional annealing module, which can, for example, have an annealing chamber 112, and the winding module having the winding chamber 106. These modules and chambers are typically provided in this order.

As shown in FIG. 3, the flexible substrate 11 is guided in a first direction and back into an essentially opposing direction. This serpentine-shaped guiding is repeated once in FIG. 3. According to different embodiments, which can be combined with other embodiments described herein, this serpentine-shaped guiding can be provided two, three, four, five or even more times.

As shown in FIG. 3, each of the chambers 102, 104, 112, and 106 include a vacuum flange 103, 105, 113, and 107, respectively. Thereby, each of the chambers are configured to be connected to a vacuum arrangement having one or more vacuum pumps. Accordingly, each of the chambers can be evacuated independently from the adjacent chamber. Therefore, according to some embodiments, which can be combined with other embodiments described herein, a sealing element can be provided between chamber 102 and chamber 104, a sealing element can be provided between chamber 104 and chamber 112, and/or a sealing element can be provided between chamber 112 and 106. Particularly, a respective sealing element can be provided between the unwinding chamber 102 and the adjacent chamber and between the winding chamber 106 and the adjacent chamber. Thereby, it is possible to exchange the roll 10 and/or roll 12 by venting the chambers 102 and 106 respectively, while maintaining a vacuum in the other chambers of the deposition apparatus 100. According to typical embodiments, the seals between the chambers can be inflatable seals or the like such that the chambers can be sealed with respect to each other while the flexible substrate 11 is provided for guidance from one chamber to the adjacent chamber.

As described above, one or more deposition sources 50 are provided in the apparatus 100. Typically, these sources can be sputter targets. However, other sources like evaporators, CVD sources and PECVD sources can also be included. Thereby, particularly if a layer stack is deposited in the deposition module, i.e. within chamber 104, two or more sources can be provided, wherein the sources can individually be selected from the group consisting of: a PVD source, a sputter source, a planar or rotatable sputter source, a planar or rotatable twin-sputter source, a CVD source, a PECVD source and an evaporator. According to some embodiments, which can be combined with other embodiments described herein, one or more sputter targets can be provided in the deposition module, e.g. one sputter target per sub-chamber 40. As shown in FIG. 3, the targets can be provided as twin targets having a first deposition surface 52 and a second deposition surface 54.

The term "twin target" refers to a pair of two targets, wherein the two targets are combined to a twin-target. A first target portion 52 and a second target portion 54 may form a twin target pair. For instance, both targets of the twin target pair may be simultaneously used in the same deposition process to coat the same substrate. Twin targets can be used to coat the same section of a substrate at the same time. According to some embodiments, which can be combined with other embodiments described herein, the two targets of a twin target include the same deposition material. According to some embodiments, the deposition apparatuses and the arrangements described above may be used such that the twin-targets are operated under middle frequency (MF). According to embodiments herein, middle frequency is a frequency in the range of 5 kHz to 100 kHz, for example, 10 kHz to 50 kHz. Sputtering from a target for a transparent conductive oxide film is typically conducted as DC sputtering. In one embodiment, the deposition apparatus and/or the target supports of the deposition apparatuses may be adapted for using one of the targets as an anode and the respective other one as a cathode. Generally, the deposition apparatus is adapted so that the operation of the targets as anode and cathode may be alternated. That means that the target portions 52 and 54 being formerly used as an anode may be used as a cathode, and the target being formerly used as a cathode may be operated as an anode.

According to embodiments described exemplarily with respect to FIG. 3, a processing drum 30 is provided. Commonly, the processing drum 30 can be utilized to cool the flexible substrate 11 during deposition, e.g. for receiving heat generated during deposition and/or the processing drum can be provided at a temperature for best deposition characteristics of the layer or layer stack to be deposited. Accordingly, the flexible substrate 11 is guided over the processing drum while the substrate is guided past the deposition sources 50.

According to some embodiments, which are shown in FIG. 4 and can be combined with other embodiments described herein, the transmission measurement device 140 may be replaced with one or more reflective measurement head(s) 240. In some embodiments, a reflective measurement head 240 integrates a light source for illuminating the coated substrate and a receiver for receiving the light reflected from the coated substrate. Such an arrangement for reflective measurement is particularly useful when substrate 11 is opaque and/or has low transmittance. With the arrangement shown in FIG. 4, a measurement signal of reflected light is outputted by reflective measurement head 240 and transmitted to detection arrangement 160. The evaluation of the measured signal is basically the same as described above for the transmission measurement but the simulated spectral curves should be adapted to the reflective measurement. Taking into account the measurement method will increase the accuracy of the simulation.

According to further embodiments, which may be combined with other embodiments described herein, an inline reflective measurement device may additionally or alternatively be located at position 240' within deposition chamber 104. Such an arrangement may be particularly useful in embodiments where annealing chamber 112 is omitted. According to even further embodiments, which may be combined with other embodiments described herein, an inline reflective measurement device may additionally or alternatively be located at position 240" within deposition chamber 104. Such an arrangement is particularly useful if apparatus 200 can operate in a reverse mode where the substrate is transported in opposite directions, e.g. first from roll 10 to roll 12 and subsequently reverse from roll 12 back to roll 10.

According to some embodiments, which can be combined with other embodiments described herein, the reflection may be measured from both sides of the substrate, i.e. from the coated side and the uncoated side. This is particularly useful when one or more of the coating layers comprise an absorbing material, e.g. a metal layer or a layer of indium tin oxide. The reflective measurements may be made from either side or, in some embodiments, even from both sides, thus obtaining independent measurement values. In some embodiments, a transmission measurement may be combined with the one or both reflective measurements in order to obtain a third independent measurement value.

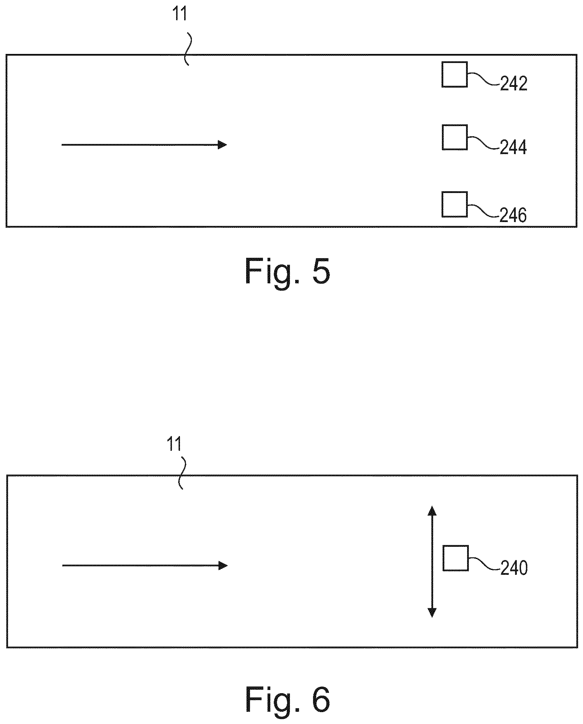

According to some embodiments, which can be combined with other embodiments described herein, more than one measuring units for reflective measurement are provided, wherein each measuring unit comprising at least one of said light sources and at least one of said detection arrangements. For example, the reflective measurement units 242, 244, 246 may be provided at locations across the width of the substrate as shown in FIG. 5. Thus, it can be monitored whether the deposition is uniform across the width of the substrate. Deviations in layer thickness, which occur only in a certain portion of the substrate, may thus be detected while they go unnoticed if layer thickness is merely monitored in a single position on the substrate.

According to some embodiments, which can be combined with other embodiments described herein, the measurement unit, for example a reflective measurement head 240 as shown in FIG. 6, may be is movable substantially perpendicular to the transport direction of substrate 11. Thus, it can be monitored whether the deposition is uniform across the width of the substrate. Deviations in layer thickness, which occur only in a certain portion of the substrate, may thus be detected while they go unnoticed if layer thickness is merely monitored in a single position on the substrate.

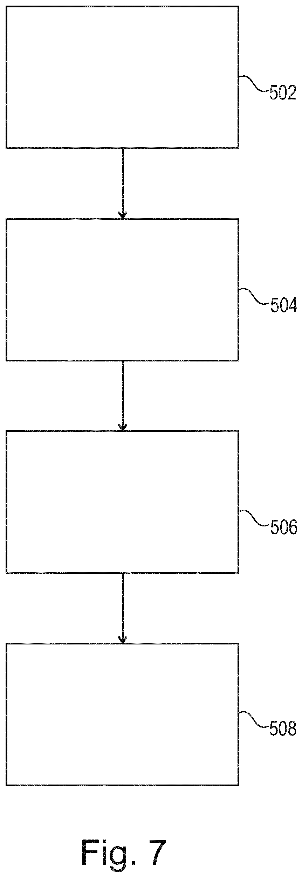

A method of inline deposition control for a vacuum deposition apparatus is shown in FIG. 7. In step 502, a substrate on which one or more deposition layers have been deposited is illuminated. In the following step 504, a spectrally resolved signal is measured, wherein the signal is light reflected at the substrate having the one or more deposition layers and/or light transmitted through the substrate having the one or more deposition layers. Thereafter in step 506, the respective thicknesses of the one or more layers are determined based on the measurement signal and a set of setpoint parameters of the deposition of the one or more deposition layers. In a subsequent step 508, the deposition of the one or more deposition layers is feed-back controller based on the determined thicknesses.is deposited on the flexible substrate in the apparatus.

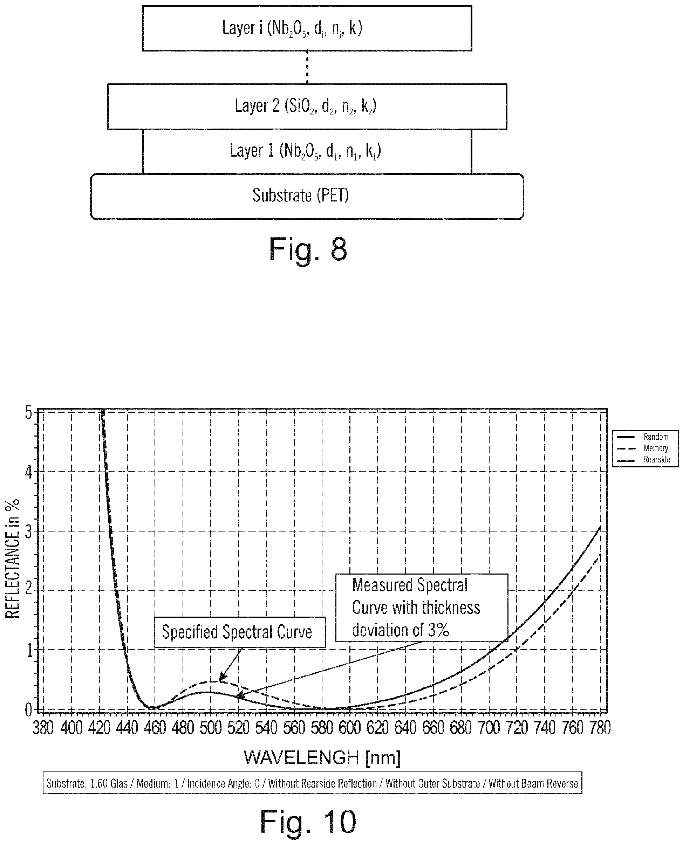

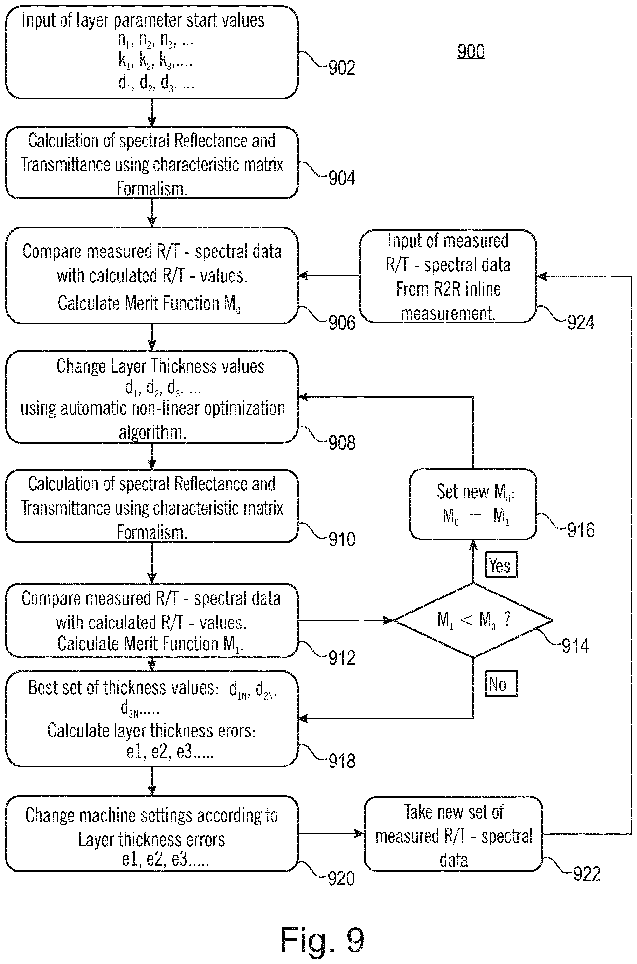

A more detailed description of a method according to some embodiments is now explained with reference to FIGS. 8 and 9. FIG. 8 shows an exemplary multilayer system with a first layer of Nb₂O₅, a second layer of SiO₂, and a final layer I of Nb₂O₅. For all the layers, their desired thicknesses dₖ, refractive indices nₖ, and extinction coefficients kₖ are known. In a first step 902, of the method 900 shown in FIG. 9 these values are used as initial values at the start of the method.

In a second step 904, the reflectance and transmittance is calculated, for example using a characteristic matrix formalism. In this formalism, each layer is represented by a 2×2 matrix containing the aforementioned layer parameters thickness d, refractive index n, and extinction coefficient k. The details of such a formalism are well-known and are described, e.g., in "Thin Film Optical Filters", by H. A. Macleod, Institute of Physics Pub., 3rd edition, 1986 , the complete content of which (particularly pages 35-39), and especially the characteristic matrix formalism, is hereby included by reference. Although being described in the context of the present embodiment, the characteristic matrix formalism may also be applied in other embodiments. Furthermore, it should be understood that other formalisms may be used to determine the individual layer thicknesses.

In a following step 906, the measured values for reflectance and/or transmittance are compared with the corresponding computed values. Such a comparison is shown in FIG. 10 which will be described in more detail below. Based on the comparison, an initial merit function M₀ is determined. It should be understood that the embodiments described herein are not limited to any particular form of merit function but that various merit functions may be employed as long as they sufficiently reflect the degree of deviation between the measured and computed spectral data.

In a following step 908, the layer thicknesses dₖ of the multilayer system are varied, for example utilizing a non-linear optimization algorithm. Although being described in the context of the present embodiment, such a non-linear optimization algorithm may also be applied in other embodiments. Furthermore, it should be understood that other optimization algorithms may be used to determine the individual layer thicknesses.

Subsequently, in step 910 the reflectance and/or transmittance values for the varied layer thicknesses are calculated, for example using the same characteristic matrix formalism as in step 904.

In subsequent step 912, a new merit function M₁ is calculated based on the new reflectance and/or transmittance values determined in step 910. Thereafter, the new merit function M₁ is compared with the initial merit function M₀ in step 914. Thus, it can be determined whether the varied layer thicknesses result in spectral data which match the measured data more closely. If this is the case, the new merit function M₁ will be smaller than the initial merit function M₀. In this case, the initial merit function M₀ will be replaced by the new merit function M₁ in step 916 and the method continues with a further variation of the layer thicknesses in step 908. In the event the new merit function M₀ is not smaller than the old merit function M₀, the iterative optimization process terminates and the current layer thicknesses d_{1N},...,d_{NN} are maintained as the best set of thickness values to fit the measured spectral curves.

Based on these best thickness values, the deviation of each layer thickness from the desired layer thickness of the process can be determined in step 918. Based on the determined thickness errors, the operational parameters of the deposition apparatus will be adjusted in step 920 so that the actual layer thicknesses come closer to the desired layer thicknesses. There are several options to vary the machine settings of the deposition process. For example, in a sputtering process a typical way for adjusting the deposition rate is reducing or increasing the feeding power for the sputter source. In a non-limiting example, the first layer (e.g. Nb₂O₅) is 5% short of the desired thickness so that the power of the sputter source will be increased by 5% (e.g. from 10 kW to 10, 5 kW). After the deposition apparatus has been adjusted, a new measurement of the spectral data is performed in step 922 and used as a new input for the control method in step 924. Based on the new measurement data, the method repeats from step 906.

In light of the above, a plurality of embodiments has been described. According to one embodiment, an apparatus for processing a flexible substrate is provided. The apparatus includes an unwinding module configured for providing the flexible substrate, a deposition module configured for depositing one or more layers on the flexible substrate, a winding module configured for winding the substrate with the coated layer(s), and an inline deposition control apparatus, wherein the inline deposition control apparatus is provided after the deposition and before the winding. Yet further embodiments, can be yielded by combination of the details, features, aspects described in the other embodiments, the dependent claims and the drawings, wherein the details, features and aspects can be provided as alternatives or in addition to each other to the extent they are not inconsistent with each other.

The embodiments described herein, can be utilized to omit or reduce the need for manual adjustment of the substrate processing apparatus, i.e. layer deposition apparatus. Replacing the manual adjustment by an experienced operator using a trial-and error method saves time, material and costs for the owner of a roll to roll coater, such that the CoO will be improved.

While the foregoing is directed to embodiments of the invention, other and further embodiments of the invention may be devised without departing from the basic scope thereof, and the scope thereof is determined by the claims that follow.

## Claims

1. An inline deposition control apparatus for a vacuum deposition apparatus (100) having more than one deposition sources (50) for depositing more than one deposition layers on a substrate (11), comprising:
one or more light sources (142, 240) adapted to illuminate the substrate having the more than one deposition layers;
a receiver (144, 240) adapted for receiving light reflected at, or transmitted through, the substrate having the more than one deposition layers;
a detection arrangement (160) connected to the receiver and adapted for spectrally resolved detection of a measurement signal provided by the receiver, wherein the measurement signal is selected from at least one of: light reflected at the substrate having the more than one deposition layers, and light transmitted through the substrate having the more than one deposition layers;
an evaluation unit (170) adapted to determine the respective thicknesses of the more than one deposition layers of the substrate based on the spectrally resolved measurement signal received as input from the detection arrangement; and
a controller (180) connected to the evaluation unit and connectable to the vacuum deposition apparatus for feed-back control of the deposition of the more than one deposition layers based on the determined respective thicknesses of the more than one deposition layers.

2. The inline deposition control apparatus according to claim 1, comprising a measuring unit for reflective measurement, the measuring unit comprising at least one of said one or more light sources and the receiver.

3. The inline deposition control apparatus according to claim 2, wherein the measuring unit is movable substantially perpendicular to a transport direction of the substrate.

4. The inline deposition control apparatus according to any of the preceding claims, wherein the evaluation unit comprises a set of setpoint parameters of the deposition of the one or more deposition layers, said set of setpoint parameters containing one or more of the following parameters: a desired material composition of the substrate, a desired thickness of the substrate, a refractive index of the substrate, an extinction coefficient of the substrate, a desired material composition of a deposition layer, a desired thickness of a deposition layer, a number of deposition layers on the substrate, a refractive index of a deposition layer, an extinction coefficient of a deposition layer.

5. The inline deposition control apparatus according to any of the preceding claims, wherein the evaluation unit is adapted to compare the spectrally resolved measurement signal with one or more simulated spectral curves based on a set of setpoint parameters.

6. The inline deposition control apparatus according to claim 5, wherein the evaluation unit is further adapted to determine an actual layer thickness for each of the one or more deposition layers from said comparison between the spectrally resolved measurement signal and the simulated spectral curves.

7. The inline deposition control apparatus according to any of the preceding claims, wherein the controller is adapted to control at least one sputter source for depositing at least one of said deposition layers.

8. The inline deposition control apparatus according to any of the preceding claims, wherein the detection arrangement includes at least one spectrometer adapted to determine a reflectance and/or transmittance of the substrate having the one or more deposition layers within a wavelength range of about 300 to about 1700 nm, particularly of about 380 to about 1100 nm.

9. The inline deposition control apparatus according to any of the preceding claims, further adapted for inline inspection of a substrate for which at least one of the following properties holds: (a) the substrate is conveyed at a speed of about 0.005 to about 0.5 m/s; (b) the substrate has a transverse width of about 200 to about 2000 mm; and (c) the substrate is under a tension of 20 to 800 N when being transported.

10. The inline deposition control apparatus according to any of the preceding claims, wherein a deposition material is selected from the group consisting of: Ag, Al, Au, Cr, Cu, Mo, Ni, NiCr, NiV, Si, stainless steel, Ti, TiO₂, Ta, Al₂O₃, aluminum-doped zinc oxide, CrOₓN_{y}, indium-doped tin oxide, MgO, Nb₂O₅, SiN, SiO₂, SiOₓN_{y} and/or
wherein the substrate is selected from group consisting of: polyethylene terephthalate, polyethylene naphthalate, polyimide, polyamide, polycarbonates, triacetyl cellulose, and metal foils.

11. A vacuum deposition apparatus (100), comprising:
more than one deposition sources (50) arranged for inline deposition of more than one deposition layers on a substrate (11); and
an inline deposition control apparatus according to any of the preceding claims,
wherein the controller of the inline deposition control apparatus is connected to the more than one deposition sources for feed-back control of the inline deposition of the more than one deposition layers on the substrate.

12. The vacuum deposition apparatus according to claim 11, wherein the substrate is a flexible substrate, the vacuum deposition apparatus comprising:
an unwinding chamber (102) including a roll for providing the flexible substrate;
a deposition chamber (104); and
a winding chamber (106) including a roll for winding the flexible substrate thereon,
wherein the more than one deposition sources are arranged in the deposition chamber and adapted for inline deposition of the more than one deposition layers on the flexible substrate, and wherein the one or more light sources and the receiver of the inline deposition control apparatus are arranged after the inline deposition by the deposition sources.

13. A method of inline deposition control for a vacuum deposition apparatus, comprising:
illuminating a substrate on which more than one deposition layers have been deposited;
measuring a spectrally resolved signal selected from at least one of: light reflected at the substrate having the more than one deposition layers, and light transmitted through the substrate having the more than one deposition layers;
determining the respective thicknesses of the more than one deposition layers based on the spectrally resolved measurement signal and a set of setpoint parameters of the deposition of the more than one deposition layers; and
feed-back controlling of the deposition of the more than one deposition layers based on the determined respective thicknesses of the more than one deposition layers.

14. The method according to claim 13, wherein determining the respective thicknesses comprises
fitting input parameters of one or more simulated spectral curves to match the spectrally resolved measurement signal.

15. The method according to claim 14, wherein determining the respective thicknesses comprises
determining the layer thicknesses from the spectrally resolved measurement signal by means of a characteristic matrix formalism together with an non-linear optimization algorithm.

## Patentansprüche

1. Inline-Ablagerungssteuerungsvorrichtung für eine Vakuumablagerungsvorrichtung (100) mit mehr als einer Ablagerungsquelle (50) zum Ablagern von mehr als einer Ablagerungsschicht auf einem Substrat (11), umfassend:
eine oder mehr Lichtquellen (142, 240), die zum Beleuchten des Substrats mit der mehr als einen Ablagerungsschicht geeignet ist;
einen Empfänger (144, 240), der zum Empfangen des Lichts, das am Substrat mit der mehr als einen Ablagerungsschicht reflektiert oder dort hindurch gesendet wird, geeignet ist;
eine Erkennungsanordnung (144, 240), die mit dem Empfänger verbunden ist und zur spektral aufgelösten Erkennung eines Messsignals, das durch den Empfänger zugeführt wird, geeignet ist, wobei das Messsignal ausgewählt ist von zumindest einem von: Licht, das am Substrat mit der mehr als einen Ablagerungsschicht reflektiert wird, und Licht, das durch das Substrat mit der mehr als einen Ablagerungsschicht gesendet wird;
eine Auswertungseinheit (170), die zum Bestimmen der jeweiligen Stärken der mehr als einen Ablagerungsschicht des Substrats auf Grundlage des spektral aufgelösten Messsignals geeignet ist, das als Eingang von der Erkennungsanordnung empfangen wird; und
eine Steuerung (180), die mit der Auswertungseinheit verbunden ist und mit der Vakuumablagerungsvorrichtung zur Rückmeldungssteuerung der Ablagerung der mehr als einen Ablagerungsschicht auf Grundlage der bestimmten jeweiligen Stärken der mehr als einen Ablagerungsschicht verbindbar ist.

2. Inline-Ablagerungssteuerungsvorrichtung nach Anspruch 1, umfassend eine Messeinheit zur Reflexionsmessung, wobei die Messeinheit zumindest eine der einen oder mehr Lichtquellen und den Empfänger umfasst.

3. Inline-Ablagerungssteuerungsvorrichtung nach Anspruch 2, wobei die Messeinheit im Wesentlichen senkrecht zu einer Transportrichtung des Substrats beweglich ist.

4. Inline-Ablagerungssteuerungsvorrichtung nach einem der vorhergehenden Ansprüche, wobei die Auswertungseinheit einen Satz von Sollwertparametern der Ablagerung der einen oder mehr Ablagerungsschichten umfasst, wobei der Satz von Sollwertparametern einen oder mehr der folgenden Parameter enthält: eine erwünschte Materialzusammensetzung des Substrats, eine erwünschte Stärke des Substrats, einen Brechungsindex des Substrats, einen Extinktionskoeffizienten des Substrats, eine erwünschte Materialzusammensetzung einer Ablagerungsschicht, eine erwünschte Stärke einer Ablagerungsschicht, eine Anzahl von Ablagerungsschichten auf dem Substrat, einen Brechungsindex einer Ablagerungsschicht, einen Extinktionskoeffizienten einer Ablagerungsschicht.

5. Inline-Ablagerungssteuerungsvorrichtung nach einem der vorhergehenden Ansprüche, wobei die Auswertungseinheit zum Vergleichen des spektral aufgelösten Messsignals mit einer oder mehr simulierten Spektralkurven auf Grundlage eines Satzes von Sollwertparametern geeignet ist.

6. Inline-Ablagerungssteuerungsvorrichtung nach Anspruch 5, wobei die Auswertungseinheit ferner zum Bestimmen einer aktuellen Schichtstärke für jede der einen oder mehr Ablagerungsschichten aus dem Vergleich zwischen dem spektral aufgelösten Messsignal und den simulierten Spektralkurven geeignet ist.

7. Inline-Ablagerungssteuerungsvorrichtung nach einem der vorhergehenden Ansprüche, wobei die Steuerung zum Steuern von zumindest einer Sputter-Quelle zum Ablagern von zumindest einer der Ablagerungsschichten geeignet ist.

8. Inline-Ablagerungssteuerungsvorrichtung nach einem der vorhergehenden Ansprüche, wobei die Erkennungsanordnung zumindest ein Spektrometer enthält, das zum Bestimmen eines Reflexionsgrads und/oder einer Durchlässigkeit des Substrats mit der einen oder mehr Ablagerungsschichten innerhalb eines Wellenlängenbereichs von ungefähr 300 bis ungefähr 1700 nm, insbesondere von ungefähr 380 bis ungefähr 1100 nm, geeignet ist.

9. Inline-Ablagerungssteuerungsvorrichtung nach einem der vorhergehenden Ansprüche, ferner geeignet zur Inline-Inspektion eines Substrats, für das zumindest eine der folgenden Eigenschaften zutrifft: a) das Substrat wird auf einer Geschwindigkeit von ungefähr 0,005 bis ungefähr 0,5 m/s befördert; b) das Substrat weist eine Transversalbreite von ungefähr 200 bis ungefähr 2000 mm auf; und c) das Substrat steht unter einer Spannung von 20 bis 800 N, wenn es transportiert wird.

10. Inline-Ablagerungssteuerungsvorrichtung nach einem der vorhergehenden Ansprüche, wobei ein Ablagerungsmaterial aus der Gruppe ausgewählt wird, die aus folgendem besteht: Ag, Al, Au, Cr, Cu, Mo, Ni, NiCr, NiV, Si, Edelstahl, Ti, TiO₂, Ta, Al₂O₃, aluminiumdotiertes Zinkoxid, CrOₓN_{y}, indiumdotiertes Zinnoxid, MgO, Nb₂O₅, SiN, SiO₂, SiOₓN_{y}, und/oder
wobei das Substrat aus der Gruppe ausgewählt wird, die aus folgendem besteht: Polyethylenterephthalat, Polyethylennaphthalat, Polyimid, Polyamid, Polycarbonate, Triacetyl-Zellulose und Metallfolien.

11. Vakuumablagerungsvorrichtung (100), umfassend:
mehr als eine Ablagerungsquelle (50), die zur Inline-Ablagerung von mehr als einer Ablagerungsschicht auf einem Substrat (11) angeordnet ist; und
eine Inline-Ablagerungssteuerungsvorrichtung nach einem der vorhergehenden Ansprüche,
wobei die Steuerung der Inline-Ablagerungssteuerungsvorrichtung mit der mehr als einer Ablagerungsquelle zur Rückmeldungssteuerung der Ablagerung der mehr als einen Ablagerungsschicht auf dem Substrat verbunden ist.

12. Vakuumablagerungsvorrichtung nach Anspruch 11, wobei das Substrat ein flexibles Substrat ist, die Vakuumablagerungsvorrichtung umfassend:
eine Abwicklungskammer (102), die eine Rolle zum Vorsehen des flexiblen Substrats enthält;
eine Ablagerungskammer (104); und
eine Aufwicklungskammer (106), die eine Rolle zum Aufwickeln des flexiblen Substrats darauf enthält,
wobei die mehr als eine Ablagerungsquelle in der Ablagerungskammer angeordnet sind und zur Inline-Ablagerung der mehr als einen Ablagerungsschicht auf dem flexiblen Substrat geeignet sind, und wobei die eine oder mehr Lichtquellen und der Empfänger der Inline-Ablagerungssteuerungsvorrichtung nach der Inline-Ablagerung durch die Ablagerungsquellen angeordnet werden.

13. Verfahren zur Inline-Ablagerungssteuerung für eine Vakuumablagerungsvorrichtung, umfassend:
Beleuchten eines Substrats, auf dem mehr als eine Ablagerungsschicht abgelagert wurde;
Messen eines spektral aufgelösten Signals, das ausgewählt ist von zumindest einem von: Licht, das am Substrat mit der mehr als einen Ablagerungsschicht reflektiert wird, und Licht, das durch das Substrat mit der mehr als einen Ablagerungsschicht gesendet wird;
Bestimmen der jeweiligen Stärken der mehr als einen Ablagerungsschicht auf Grundlage des spektral aufgelösten Messsignals und eines Satzes von Sollwertparametern der Ablagerung der mehr als einen Ablagerungsschicht; und
Rückmeldungssteuern der Ablagerung der mehr als einen Ablagerungsschicht auf Grundlage der bestimmten jeweiligen Stärken der mehr als einen Ablagerungsschicht.

14. Verfahren nach Anspruch 13, wobei das Bestimmen der jeweiligen Stärken umfasst:
Anlegen von Eingangsparametern von einer oder mehr simulierten Spektralkurven zum Übereinstimmen mit dem spektral aufgelösten Messsignal.

15. Verfahren nach Anspruch 14, wobei das Bestimmen der jeweiligen Stärken umfasst:
Bestimmen der Ablagerungsstärken aus dem spektral aufgelösten Messsignal mithilfe eines Kennzeichenmatrixformalismus mit einem nichtlinearen Optimierungsalgorithmus.

## Revendications

1. Dispositif de commande de dépôt en ligne pour un dispositif de dépôt sous vide (100) présentant plus d'une source de dépôt (50) pour le dépôt de plus d'une couche de dépôt sur un substrat (11), comprenant :
une ou plusieurs sources de lumière (142, 240) adaptées pour éclairer le substrat présentant les plus d'une couche de dépôt ;
un récepteur (144, 240) adapté pour recevoir de la lumière réfléchie au niveau du substrat ou transmise à travers celui-ci, le substrat présentant les plus d'une couche de dépôt ;
un système de détection (160) relié au récepteur et adapté pour une détection à résolution spectrale d'un signal de mesure fourni par le récepteur, où le signal de mesure est sélectionné à partir de l'une au moins parmi : une lumière réfléchie au niveau du substrat présentant les plus d'une couche de dépôt, et une lumière transmise à travers le substrat présentant les plus d'une couche de dépôt ;
une unité d'évaluation (170) adaptée pour déterminer les épaisseurs respectives des plus d'une couche de dépôt du substrat sur la base du signal de mesure à résolution spectrale reçu comme entrée depuis le système de détection ; et
un moyen de commande (180) relié à l'unité d'évaluation et apte à être relié au dispositif de dépôt sous vide pour une commande à rétroaction du dépôt des plus d'une couche de dépôt sur la base des épaisseurs respectives déterminées des plus d'une couche de dépôt.

2. Dispositif de commande de dépôt en ligne selon la revendication 1, comprenant une unité de mesure pour la mesure de la réflexion, l'unité de mesure comprenant au moins l'une desdites une ou plusieurs sources de lumière et le récepteur.

3. Dispositif de commande de dépôt en ligne selon la revendication 2, dans lequel l'unité de mesure est déplaçable substantiellement perpendiculairement à la direction de transport du substrat.

4. Dispositif de commande de dépôt en ligne selon l'une quelconque des revendications précédentes, dans lequel l'unité d'évaluation comprend un ensemble de paramètres de consigne du dépôt des une ou plusieurs couches de dépôt, ledit ensemble de paramètres de consigne contenant un ou plusieurs des paramètres suivants : une composition de matériau de substrat souhaitée, une épaisseur de substrat souhaitée, un indice de réfraction du substrat, un coefficient d'extinction du substrat, une composition de matériau souhaitée d'une couche de dépôt, une épaisseur souhaitée d'une couche de dépôt, un nombre de couches de dépôt sur le substrat, un indice de réfraction d'une couche de dépôt, un coefficient d'extinction d'une couche de dépôt.

5. Dispositif de commande de dépôt en ligne selon l'une quelconque des revendications précédentes, dans lequel l'unité d'évaluation est adaptée pour comparer le signal de mesure à résolution spectrale avec une ou plusieurs courbes spectrales simulées, sur la base d'un ensemble de paramètres de consigne.

6. Dispositif de commande de dépôt en ligne selon la revendication 5, dans lequel l'unité d'évaluation est en outre adaptée pour déterminer une épaisseur de couche réelle pour chacune des une ou plusieurs couches de dépôt à partir de la comparaison entre le signal de mesure à résolution spectrale et les courbes spectrales simulées.

7. Dispositif de commande de dépôt en ligne selon l'une quelconque des revendications précédentes, dans lequel le moyen de commande est adapté pour commander au moins une source de pulvérisation pour le dépôt de l'une au moins desdites couches de dépôt.

8. Dispositif de commande de dépôt en ligne selon l'une quelconque des revendications précédentes, dans lequel le système de détection comprend au moins un spectromètre adapté pour déterminer une réflectance et/ou une transmittance du substrat présentant les une ou plusieurs couches de dépôt, dans une plage de longueurs d'onde d'environ 300 à environ 1700 nm, en particulier d'environ 380 à environ 1100 nm.

9. Dispositif de commande de dépôt en ligne selon l'une quelconque des revendications précédentes, en outre adapté pour une inspection en ligne d'un substrat présentant au moins l'une des propriétés suivantes :
(a) le substrat est transporté à une vitesse d'environ 0,005 à environ 0,5 m/s ; (b) le substrat présente une largeur transversale d'environ 200 à environ 2000 nm ; et (c) le substrat est sous une tension de 20 à 800 N pendant son transport.

10. Dispositif de commande de dépôt en ligne selon l'une quelconque des revendications précédentes, dans lequel un matériau de dépôt est sélectionné parmi le groupe comprenant : Ag, Al, Au, Cr, Cu, Mo, Ni, NiCr, NiV, Si, l'acier inoxydable, Ti, TiO₂, Ta, Al₂O₃, l'oxyde de zinc dopé d'aluminium, CrOₓN_{y}, l'oxyde d'étain dopé d'indium, MgO, Nb₂O₅, SiN, SiO₂, SiOₓN_{y} et/ou
dans lequel le substrat est sélectionné parmi un groupe comprenant : le polyéthylène téréphtalate, le polyéthylène naphtalate, le polyimide, le polyamide, les polycarbonates, le triacétyl cellulose et des feuilles métalliques.

11. Dispositif de dépôt sous vide (100) comprenant :
plus d'une source de dépôt (50) disposées pour le dépôt en ligne de plus d'une couche de dépôt sur un substrat (11) ; et
un dispositif de commande de dépôt en ligne selon l'une quelconque des revendications précédentes,
dans lequel le moyen de commande du dispositif de commande de dépôt en ligne est relié aux plus d'une source de dépôt pour la commande à rétroaction du dépôt en ligne des plus d'une couche de dépôt sur le substrat.

12. Dispositif de dépôt sous vide selon la revendication 11, dans lequel le substrat est un substrat souple, le dispositif de dépôt sous vide comprenant :
une chambre de déroulement (102) comprenant un rouleau destiné à fournir le substrat souple ;
une chambre de dépôt (104) ; et
une chambre d'enroulement (106) comprenant un rouleau sur lequel le substrat souple est enroulé,
dans lequel les plus d'une source de dépôt sont disposées dans la chambre de dépôt et adaptées pour le dépôt en ligne des plus d'une couche de dépôt sur le substrat souple, et dans lequel les une ou plusieurs sources de lumière et le récepteur du dispositif de commande de dépôt en ligne sont disposés après le dépôt en ligne par les sources de dépôt.

13. Procédé de commande de dépôt en ligne pour un dispositif de dépôt sous vide, comprenant :
l'éclairage d'un substrat sur lequel plus d'une couche de dépôt ont été déposées ;
la mesure d'un signal à résolution spectrale sélectionné à partir de l'une au moins parmi : une lumière réfléchie au niveau du substrat comportant les plus d'une couche de dépôt, et une lumière transmise à travers le substrat comportant les plus d'une couche de dépôt ;
la détermination des épaisseurs respectives des plus d'une couche de dépôt du substrat sur la base du signal de mesure à résolution spectrale et d'un ensemble de paramètres de consigne du dépôt des plus d'une couche de dépôt ; et
la commande à rétroaction du dépôt des plus d'une couche de dépôt sur la base des épaisseurs respectives déterminées des plus d'une couche de dépôt.

14. Procédé selon la revendication 13, dans lequel la détermination des épaisseurs respectives comprend :
l'adaptation de paramètres d'entrée d'une ou de plusieurs courbes spectrales simulées au signal de mesure à résolution spectrale.

15. Procédé selon la revendication 14, dans lequel la détermination des épaisseurs respectives comprend :
la détermination des épaisseurs de couche à partir du signal de mesure à résolution spectrale au moyen d'un formalisme de matrice caractéristique avec un algorithme d'optimisation non linéaire.
